# EUROPÄISCHE PATENTSCHRIFT

(11) **EP 0 962 673 B1**
(45) Veröffentlichungstag und Bekanntmachung des Hinweises auf die Patenterteilung: **04.08.2004**
(21) Anmeldenummer: 99110452.2
(22) Anmeldetag: 29.05.1999
(51) Int. Cl.: F16C 33/12, F16C 33/14

(54) **Gleitlagerschale und Verfahren zu ihrer Herstellung**
Sliding bearing shell and method of making the same
Coussinet de palier lisse et son procédé de fabrication

(30) Priorität: 02.06.1998 DE 19824308
(43) Veröffentlichungstag der Anmeldung: 08.12.1999
(73) Patentinhaber: Federal-Mogul Wiesbaden GmbH & Co.KG, 65201 Wiesbaden (DE)
(72) Erfinder: Andler, Gerd, 60594 Frankfurt (DE); Heinss, Jens-Peter, Dr., 01157 Dresden (DE); Goedicke, Klaus, 01307 Dresden (DE); Metzner, Christoph, 01474 Pappritz (DE)

(56) Entgegenhaltungen:
- EP-A- 0 376 368
- WO-A-91/00375
- DE-A- 3 606 529
- DE-A- 19 514 836
- DE-C- 19 514 835
- US-A- 4 006 268
- US-A- 4 961 831

## Beschreibung

Die Erfindung betrifft eine Gleitlagerschale mit einem Trägerkörper und mit mindestens einer metallischen Gleitschicht, die mittels Elektronenstrahlbedampfung aufgebracht ist und die in einem Matrixmaterial mindestens eine fein dispergierte Komponente aufweist, deren Atomgewicht größer ist als das des Matrixmaterials. Die Erfindung bezieht sich auch auf ein Verfahren zur Herstellung einer Gleitlagerschale mit einer solchen Gleitschicht gemäß dem Oberbegriff des Patentanspruchs 10.

Allgemein bestehen derart eingesetzte Gleitelemente aus Mehrschichtverbundsystemen folgenden Aufbaues: Stahlstützkörper als Trägerwerkstoff, Lagermetallschicht aus einer Cu-, Al- oder Weißmetall-Legierung und einer sogenannten Lauf- oder Drittschicht oder Gleitschicht, die entweder durch ein galvanisches Verfahren (E. Römer: Dreistofflager aus GLYCO 40; GLYCO-Ingenieurbericht 8/67) oder durch einen Kathodenzerstäubungsprozeß (Sputtern) aufgebracht werden kann, wie dies in der EP 0 256 226 B1 beschrieben ist. Nachteilig bei den galvanisch aufgebrachten Schichten, meist auf Pb- oder Sn-Basis, ist die oftmals nicht ausreichende Korrosionsbeständigkeit bzw. ihre geringe Verschleißbeständigkeit. Weiterhin ist der Galvanikprozeß an sich aus Umweltgesichtspunkten als kritisch anzusehen.

Werden die Laufschichten mittels der Sputter-Technik aufgebracht, stellt dies aufgrund der hierbei realisierbaren geringen Abscheidungsraten und des hohen anlagentechnischen Aufwandes einen erheblichen Kostenfaktor für das komplette Gleitelement dar.

Die GB 2270 927 beschreibt Aluminiumlegierungen, in denen der Sn-Gehalt in der gesamten Schicht konstant und zwischen 10 und 80 % liegen kann. Aus Tabelle 1 Seite 10 und 11 dieser Anmeldung geht hervor, daß mit steigendem Zinngehalt die mögliche Grenzlast, bis das Lager zum Fressen neigt, ansteigt, demgegenüber aber die Belastbarkeit ab einem bestimmten Zinngehalt wieder drastisch abfällt. Hinweise zur Verbesserung des Einlaufverhaltens sind in dieser Schrift nicht vorhanden. Als Herstellungsverfahren zum Aufbringen der Laufschicht wird in dieser Anmeldung das Sputtern erwähnt.

Die EP 0 376 368 B1 beschreibt ein sehr aufwendiges Verfahren zur Herstellung eines Lagers, das sich hinsichtlich guter Notlauf- und Einlaufeigenschaften auszeichnet. Auch in dieser Anmeldung handelt es sich um Aluminium-Zinn-Legierungen, die mittels eines Sputterprozesses appliziert werden. Kernpunkt dieser Anmeldung ist, daß die in der metallischen Grundmasse der Lagerlegierung eingelagerten Teilchen bezüglich ihres Durchmessers einer statistischen Normalverteilung gehorchen, sowie bis zu 1,0 Masse-% Sauerstoff in der Laufschicht eingelagert ist und nach einer Wärmebehandlung die Mikrohärte der Laufschicht abnimmt. Hierdurch werden die Einbettfähigkeit, die Notlaufeigenschaften und die Freßunempfindlichkeit verbessert.

Die WO 91/00375 beschreibt ein Lager, dessen Laufschicht aus einer Grundmasse (z.B. Aluminium) mit einer darin fein dispergierten zweiten Phase (z.B. Zinn) besteht. Auch hierbei findet das Sputterverfahren Anwendung. Ziel dieser Erfindung ist es ein Lager herzustellen, dessen Aufbau der Laufschicht so geartet ist, daß der Gehalt der zweiten Phase (z.B. Zinn) in der Laufschicht sich als Funktion der Dicke der Laufschicht kontinuierlich von 0 % in den untersten Lagen bis hin zu 100 % in den obersten Lagen erhöht. Dies wird zum einen durch den Einsatz mehrerer Targets unterschiedlicher Zusammensetzung bzw. sich ändernder Sputterparameter beim Beschichten realisiert. Derart hergestellte Laufschichten zeigen sehr gute Eigenschaften hinsichtlich ihres Verschleiß- und Ermüdungsverhaltens, was allerdings mit einem sehr aufwendigen Verfahren erlangt wird.

Aus den DE 195 14 835 A1 und DE 195 14 836 A1 ist es bekannt, mittels Elektronenstrahlbedampfung Gleitschichten auf konkav gekrümmten Gleitelementen abzuscheiden, wobei in beiden Schriften die Ausprägung bestimmter Schichtdickenprofile im Vordergrund steht. Um bei Gleitlagerschalen eine gleichmäßige Schichtdicke zu erzielen, wird gemäß der DE 195 14 835 A1 während des Aufdampfens der Gleitschicht der Verdampfer und der Trägerkörper relativ zueinander geradlinig mit unterschiedlicher Geschwindigkeit bewegt. Hierzu sind entsprechende Verstelleinrichtungen innerhalb der Beschichtungskammer erforderlich. Bei der DE 195 14 836 A1 hingegen soll gezielt eine ungleichmäßige Schichtdicke eingestellt werden. Die Schichtdicke des Gleitelementes ist im Scheitelbereich am größten und nimmt zu den Teilflächen hin kontinuierlich ab. Um dies zu realisieren, sieht das Verfahren vor, daß ein Abstand vom Verdampfer bis zum Scheitelbereich der Gleitlagerschale von 150 bis 350 mm eingestellt wird, daß während des Aufdampfens der Schicht der Verdampfer und der Trägerkörper fest zueinander positioniert sind und daß die Kondensationsrate für die Abscheidung im Scheitelbereich mit mindestens 80 nm/s eingestellt wird.

Aus der DE 36 06 529 A1 ist ein Verfahren zur Herstellung von Schichtwerkstoffen oder Schichtwerkstücken durch Aufdampfen mindestens eines metallischen Werkstoffs auf ein metallisches Substrat bekannt, bei dem ebenfalls ein Elektronenstrahlbedampfungsverfahren für das Aufbringen der Gleitschicht eingesetzt. Das Verfahren findet unter Restgasatmosphäre bei Drücken im Bereich von 10⁻² - 10⁻³ mbar statt, wobei der Werkstoff gleichzeitig mit dem Aufdampfen dispersionsgehärtet bzw. dispersionsverfestigt wird. Es werden Beschichtungsraten von etwa 0,3 µm/s eingestellt. Während des Aufdampfens wird das Substrat auf eine Temperatur zwischen 200°C und 800°C gehalten. Beim Aufdampfen von Aluminiumlegierungen liegt die Temperatur des Substrates bei 200°C bis 300°C und bei Kupfer-Blei-Legierungen im Bereich von 500°C bis 700°C. Die Belastbarkeit der nach diesem Verfahren hergestellten Schichten ist deutlich besser als die mit pulvermetallurgischen Verfahren hergestellten Schichten. Bei dieser Anmeldung steht im Vordergrund, durch eine Dispersionsverfestigung, z.B. durch Erzeugen von Oxiden während des Bedampfens einen definierten Hartphasenanteil in der Gleitschicht zu erzeugen.

Hinweise auf unterschiedliche Verteilungen der Legierungskomponenten gibt es in diesen drei Schriften, die jeweils als gattungsbildend angesehen werden können, zur Elektronenstrahlbedampfung nicht. Für einige Anwendungsfälle sind die Belastbarkeit bzw. das Einlaufverhalten nicht ausreichend.

Aufgabe der Erfindung ist es, eine Gleitlagerschale zu schaffen, die sich vorzugsweise in den hochbeanspruchten Bereichen durch gutes Not- und Einlaufverhalten in Kombination mit hohen Grenzlasten bis zum Eintritt eines Lagerfressers auszeichnet. Es ist auch Aufgabe der Erfindung, ein kostengünstiges Verfahren auf der Basis der Elektronenstrahlbedampfung zur Herstellung solcher Gleitlagerschalen bereitzustellen, das außerdem auf einfache Weise eine gleichmäßige Schichtdicke über den gesamten Lagerschalenumfang gewährleistet.

Die Gleitlagerschale ist dadurch gekennzeichnet, daß die Konzentration der fein dispergierten Komponente vom Scheitelbereich der Gleitlagerschale zum Teilflächenbcreich hin kontinuierlich abnimmt.

Eine derart aufgebaute Gleitschicht hat den Vorteil, daß im höchstbelasteten Bereich, nämlich im Scheitelbereich, diejenige Legierungskomponente, die maßgeblich das Not- und Einlaufverhalten positiv beeinflußt, in der höchsten Konzentration vorliegt. Ein weiterer Vorteil besteht darin, daß die relativ teure, fein dispergierte Komponente nur in den Bereichen in entsprechend hoher Konzentration vorhanden ist, wo sie für das Not- und Einlaufverfahren vorzugsweise benötigt wird.

Da die Gleiteigenschaften der höchstbelasteten Bereiche die Lebensdauer des gesamten Gleitlagers beeinflussen, wird durch die Konzentrationserhöhung der fein dispergierten Legierungskomponente im Scheitelbereich auch eine Erhöhung der Lebensdauer sichergestellt.

Vorzugsweise ist die Konzentration der fein dispergierten Komponente im Scheitelbereich um den Faktor 1,2 bis 1,8, vorteilhafterweise 1,3 bis 1,6, höher als im Teilflächenbereich.

Die Konzentration der fein dispergierten Komponente ist gemäß einer ersten Ausführungsform über die Dicke der Gleitschicht konstant.

Diese Konzentrationsverteilung in Umfangsrichtung kann auch mit einer unterschiedlichen Konzentration gemäß einer zweiten Ausführungsform über die Schichtdicke kombiniert werden, wobei vorzugsweise die Konzentration der fein dispergierten Komponente von dem unteren, d.h. der trägerkörpernahen Seite, zum oberen Bereich der Gleitschicht kontinuierlich zunimmt. Diese Ausführungsform der Gleitschicht wird dann gewählt, wenn der Gegenläufer der Gleitlagerschale hohe Oberflächenrauhigkeiten aufweist, wie das z.B. bei Gußwellen der Fall ist.

Vorzugsweise ist die Konzentration der fein dispergierten Komponente im oberen Bereich der Gleitschicht bis zum 2fachen größer als im unteren Bereich.

Die Konzentration der fein dispergierten Komponente beträgt vorteilhafterweise im Scheitelbereich zwischen 10 und 70 Masse-%.

Das Matrixmaterial besteht vorzugsweise aus Aluminium, wobei die fein dispergierte Komponente aus Zinn, Blei, Wismut und/oder Antimon bestehen kann. Als weitere Legierungskomponente kann die Gleitschicht Kupfer, Zink, Silizium, Mangan und/oder Nickel einzeln oder in Kombination bis zu 5 Masse-% aufweisen.

Als Trägerkörper kommen Stahlstützschalen, aber auch Stahl/CuPbSn-Verbundwerkstoffe, Stahl/Aluminium- oder Stahl/Weißmetall-Verbundwerkstoffe in Frage. Bevorzugte Legierungssysteme, aus denen die Gleitschicht besteht, sind AlSnCu, AlSnPb und AlSnSi. Bei einer Gleitschicht aus einer Zinn-Legierung nimmt der Zinn-Anteil in der Gleitschicht vom Scheitelpunkt zu den Teilflächen des Gleitelements ab. D.h. die Gleitschicht besitzt Bereiche mit hohen und niedrigen Zinn-Anteilen. Dadurch ist es erstmals möglich, die Vorteile eines hohen und eines niedrigen Zinn-Anteils in der Gleitschicht gleichzeitig zu nutzen. Während der Bereich mit hohem Zinn-Anteil ein gutes Einlaufverhalten des Gleitelements gewährleistet, sichern die Bereiche mit niedrigem Zinn-Anteil die große Tragfähigkeit des Gleitelements.

Die Dicke der Gleitschicht ist über den gesamten Umfang vorzugsweise gleichmäßig.

Das Verfahren zur Herstellung solcher Gleitschichten von Gleitlagerschalen sieht vor, daß während des Beschichtungsvorgangs im Scheitelbereich der Lagerschale ein Gasdruck von 0,1 bis 5 Pa eingestellt wird.

Die Gasmoleküle zwischen dem Verdampfertiegel und der zu beschichtenden Fläche bewirken eine unterschiedliche Streuung der Legierungskomponenten während des Bedampfungsprozesses.

Der Streuwinkel bzw. der Grad der Streuung ist hierbei aus kinetischen Gründen abhängig vom spezifischen Gewicht der einzelnen verdampften Legierungselemente. Die Folge hiervon ist, daß schwere Elemente, wie z.B. Zinn weniger stark gestreut werden als leichtere Elemente, wie z.B. Aluminium. Das Resultat dieser Streuprozesse besteht darin, daß die schweren Elemente im Scheitelbereich der Gleitlagerschale in höherer Konzentration abgeschieden werden als im Teilflächenbereich. Mittels dieser Streuung an den Gasmolekülen ist es möglich, je nachdem in welchem Druckbereich bei der Elektronenstrahlbedampfung gearbeitet wird, die Zusammensetzung der Laufschicht in weiten Grenzen zu variieren.

Überraschenderweise sind die mit der Gasstreuung hergestellten Schichten entgegen der Meinung der Fachwelt kompakt und in ihren Eigenschaften bezüglich Verschleißfestigkeit und Tragfähigkeit den konventionell oder ohne zusätzliche Maßnahmen beim Elektronenstrahlbedampfen hergestellten Gleitelementen überlegen.

Es hat sich darüber hinaus überraschend herausgestellt, daß sich außer einer unterschiedlichen Konzentrationseinstellung auch gleichzeitig eine gleichmäßige Schichtdicke einstellt, so daß zusätzliche Maßnahmen, wie sie aus der DE 195 14 835 A1 bekannt sind, entbehrlich sind.

Das Herstellungsverfahren wird dadurch erheblich vereinfacht.

Vorzugsweise ist der Gasdruck während des Beschichtungsprozesses auf ± 0,05 Pa konstant zu halten.

Das Verfahren kann weiter modifiziert werden, indem während des Beschichtungsprozesses der Gasdruck kontinuierlich verändert wird. Wenn der Gasdruck als Funktion der Bedampfungszeit verändert wird, wird außer einem gradierten Aufbau der Gleitschicht in Umfangsrichtung auch eine Variation der Zusammensetzung über die Schichtdicke erzielt.

Vorzugsweise wird der Gasdruck von 0,1 Pa zu Beginn bis 1 Pa am Ende des Bedampfungsprozesses kontinuierlich erhöht. Die Zunahme des Gasdruckes bewirkt, daß die Legierungskomponente mit dem geringen Atomgewicht zunehmend stärker gestreut wird als die schweren Legierungselemente, wodurch sich der Konzentrationsunterschied zwischen Scheitelbereich und Teilflächenbereich im Laufe des Verfahrens verstärkt. Damit ändert sich auch die Konzentration der Legierungskomponenten über die Schichtdicke.

Vorzugsweise wird als Edelgas Argon, Helium oder Neon verwendet.

Dabei muß ein lotrechter Abstand der Gleitlagerschale vom Verdampfertiegel auf das 2- bis 7fache des Gleitlagerschalendurchmessers eingestellt werden und die Beschichtungsrate im Scheitelbereich auf mindestens 20 nm/s eingestellt werden.

Die Erfindung wird nachfolgend anhand eines Ausführungsbeispiels und anhand der Zeichnungen näher erläutert. In den Zeichnungen zeigen:
- Fig. 1: eine perspektivische Darstellung einer Gleitlagerschale,
- Fig. 2: ein Diagramm, das die Legierungszusammensetzung der Gleitschicht im Scheitelbereich zeigt,
- Fig. 3: ein Diagramm, das die Legierungszusammensetzung der Gleitschicht im Teilflächenbereich zeigt,
- Fig. 4: ein Diagramm, das die in einem Underwood-Test erzielbaren Grenzlasten von Gleitlagerschalen mit erfindungsgemäß hergestellten Gleitschichten im Vergleich zu herkömmlichen Ternär- und Zweistofflagern zeigt.

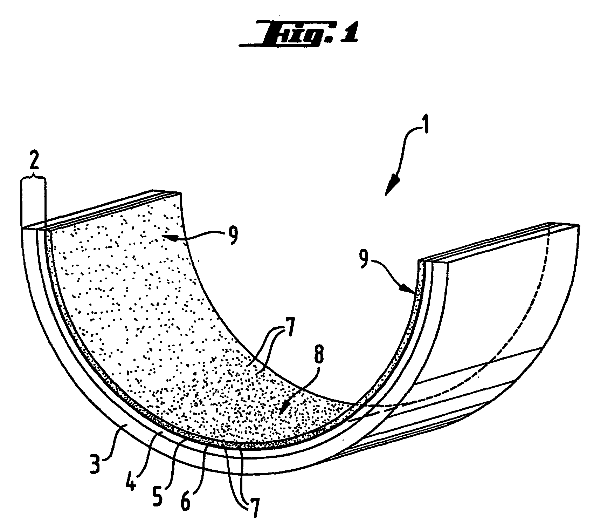

In der Fig. 1 ist eine Gleitlagerschale 1 mit einem Trägerkörper 2 und einer Gleitschicht 6 dargestellt. Der Trägerkörper 2 besteht aus einer Stahlstützschale 3, auf die eine CuPbSn-Legierung 4 durch einen Gieß- oder Sinterprozeß sowie eine Diffusionssperrschicht 5 aufgebracht wurde. Der Kohlenstoffgehalt des Stahls liegt zwischen 0,03 % und 0,3 %.

Nach verschiedenen an sich bekannten Glüh- und Umformprozessen werden aus einem Band durch Pressen von Bandstücken einer definierten Länge die Gleitlagerschalen hergestellt. Nach einer Oberflächenbearbeitung dieser Lager durch Bohren oder Rollen werden die Lagerschalen durch einen galvanischen oder einen PVD-Prozeß mit einer Diffusionssperrschicht 5 aus Nickel oder einer Nickellegierung versehen. Danach wird der Trägerkörper entfettet und in eine Vakuumverdampfungsanlage eingebracht. Hier erfolgt ein weitere Oberflächenreinigung bzw. Aktivierung durch einen Zerstäubungsätzprozeß.

Nach dem Evakuieren der Beschichtungskammer wird diese mit Argon geflutet, wobei ein Druck von etwa 1 Pa eingestellt wird. Im Anschluß daran wird der Trägerkörper 2 durch Elektronenstrahlbedampfen von AlSn20Cu aus einem Verdampfertiegel mittels einer axialen Elektronenkanone beschichtet. Die Schichtdicke der abgeschiedenen Gleitschicht 6 aus AlSn20Cu liegt bei etwa (16 ± 4) µm.

Während des Bedampfungsprozesses wurde der Argondruck bei 1 Pa konstantgehalten, die Temperatur des Trägerkörpers lag bei 190°C bis 200°C und die Leistung der Elektronenkanone betrug 40 bis 60 kW. Die Abscheidungsrate betrug mindestens 20 nm/s.

Die Gleitschicht 6 weist im Scheitelbereich 8 eine deutlich höhere Konzentration an Zinn auf als im Teilflächenbereich 9. Die Zinnteilchen sind durch die Punkte 7 gekennzeichnet. Die höhere Konzentration wird durch eine höhere Punktdichte im Scheitelbereich 8 gekennzeichnet.

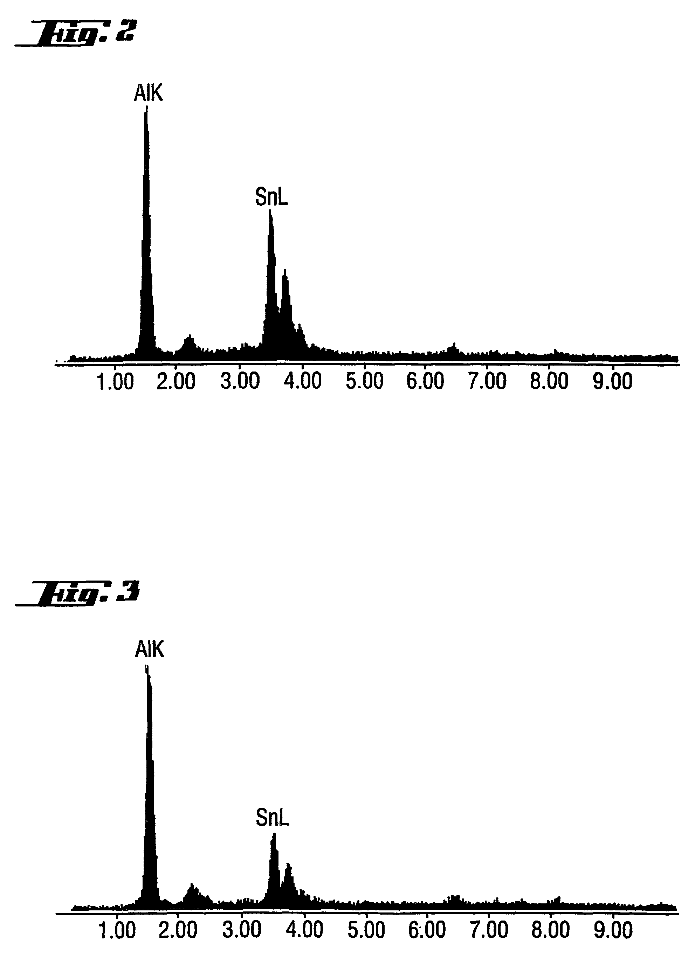

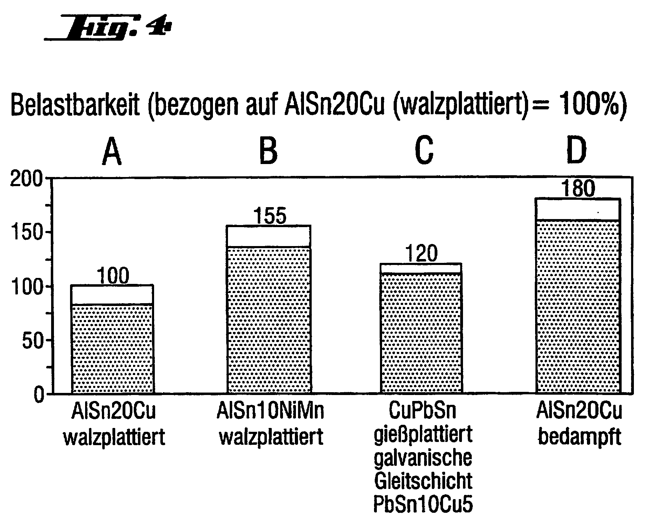

In den Fign. 2 und 3 ist die Legierungszusammensetzung im Scheitelbereich (Fig. 2) und im Teilflächenbereich (Fig. 3) dargestellt. Der Zinngehalt wurde am Rasterelektronenmikroskop mittels EDX für eine definierte Fläche der aufgedampften AlSn20Cu-Schicht bestimmt. Die Konzentration des Zinns liegt im Scheitelbereich 8 um den Faktor 1,4 höher als im Teilflächenbereich, wobei die Werte aus der Integration über die Zinn-Peaks ermittelt wurden.

Die Fig. 4 zeigt die im Underwood-Prüfstand erzielbaren Grenzlasten von der erfindungsgemäß mit gradierter Laufschicht hergestellten Lagerschalen im direkten Vergleich zu herkömmlichen Ternär- und Zweistofflagern. Als Basis wurde bei diesen Versuchen ein Aluminium-Zweistofflager (Balken A) mit einer Gleitschicht aus AlSn20Cu gewählt (als 100 % angesehen). Höhere Belastbarkeiten läßt ein Zweistofflager auf AlSn-Basis (Balken B) zu, dessen Matrix durch die Legierungselemente Nickel und Mangan verfestigt ist. Das ternäre Lager (Balken C) des Aufbaues Stahl/Bleibronze/Galvanikschicht (PbSn10Cn5) erlaubt Lasten, die zwischen den zuvor beschriebenen Zweistofflagern liegen. Wie Fig. 4 zeigt, liegen die erfindungsgemäß bedampften Gleitlager (Balken D) hinsichtlich ihrer Belastbarkeit über den herkömmlichen Lagersystemen.

### Bezugszeichen

- 1: Gleitlagerschale
- 2: Trägerkörper
- 3: Stahlstützschale
- 4: CuPbSn-Schicht
- 5: Diffusionssperrschicht
- 6: Gleitschicht
- 7: Zinnteilchen
- 8: Scheitelbereich
- 9: Teilflächenbereich

## Patentansprüche

1. Gleitlagerschale mit einem Trägerkörper und mit mindestens einer metallischen Gleitschicht, die mittels Elektronenstrahlbedampfung aufgebracht ist und die in einem Matrixmaterial mindestens eine fein dispergierte Komponente aufweist, deren Atomgewicht größer ist als das des Matrixmaterials, **dadurch gekennzeichnet,**
**daß** die Konzentration der fein dispergierten Komponente (7) vom Scheitelbereich (8) der Gleitlagerschale (1) zum Teilflächenbereich (9) hin kontinuierlich abnimmt.

2. Gleitlagerschale nach Anspruch 1, **dadurch gekennzeichnet, daß** die Konzentration der fein dispergierten Komponente (7) im Scheitelbereich (8) um den Faktor 1,2 bis 1,8 größer ist als im Teilflächenbereich (9).

3. Gleitlagerschale nach Anspruch 1 oder 2, **dadurch gekennzeichnet, daß** die Konzentration der fein dispergierten Komponente (7) über die Dicke der Gleitschicht (6) konstant ist.

4. Gleitlagerschale nach einem der Ansprüche 1 oder 2, **dadurch gekennzeichnet, daß** die Konzentration der fein dispergierten Komponente (7) vom unteren zum oberen Bereich der Gleitschicht (6) kontinuierlich zunimmt.

5. Gleitlagerschale nach einem der Ansprüche 1 bis 4, **dadurch gekennzeichnet, daß** die Konzentration der fein dispergierten Komponente (7) im Scheitelbereich (8) zwischen 10 und 70 Masse-% beträgt.

6. Gleitlagerschale nach einem der Ansprüche 4 oder 5, **dadurch gekennzeichnet, daß** die Konzentration der fein dispergierten Komponente (7) im oberen Bereich der Gleitschicht (6) bis zum 2fachen größer ist als im unteren Bereich.

7. Gleitlagerschale nach einem der Ansprüche 1 bis 6, **dadurch gekennzeichnet, daß** das Matrixmaterial aus Aluminium besteht und daß die fein dispergierte Komponente (7) aus Zinn, Blei, Wismut und/oder Antimon besteht.

8. Gleitlagerschale nach einem der Ansprüche 1 bis 7, **dadurch gekennzeichnet, daß** die Gleitschicht (6) als weitere Legierungskomponente Kupfer, Zink, Silizium, Mangan und/oder Nickel einzeln oder in Kombination bis zu 5 Masse-% aufweist.

9. Gleitlagerschale nach einem der Ansprüche 1 bis 8, **dadurch gekennzeichnet, daß** die Dicke der Gleitschicht (6) über den gesamten Umfang gleichmäßig ist.

10. Verfahren zur Herstellung einer Gleitlagerschale mit mindestens einer Gleitschicht aus einer metallischen Legierung, die in einer Beschichtungskammer mittels Elektronenstrahlbedampfung auf einen Trägerkörper aufgebracht wird und die in einem Matrixmaterial eine fein dispergierte Komponente aufweist, deren Atomgewicht größer ist als das des Matrixmaterials ist, **dadurch gekennzeichnet,**
**daß** während des Beschichtungsvorgangs im Scheitelbereich der Lagerschale ein Gas mit einem Druck von 0,1 bis 5 Pa eingestellt wird.

11. Verfahren nach Anspruch 10, **dadurch gekennzeichnet, daß** während des Bedampfungsprozesses der Gasdruck kontinuierlich verändert wird.

12. Verfahren nach Anspruch 11, **dadurch gekennzeichnet, daß** der Gasdruck von 0,1 Pa zu Beginn bis 1 Pa am Ende des Bedampfungsprozesses kontinuierlich erhöht wird.

13. Verfahren nach einem der Ansprüche 10 bis 12, **dadurch gekennzeichnet, daß** als Gas ein Edelgas Argon, Helium oder Neon verwendet wird.

14. Verfahren nach einem der Ansprüche 10 bis 13, **dadurch gekennzeichnet, daß** der lotrechte Abstand der Gleitlagerschale vom Verdampfungstiegel auf das 2- bis 7fache des Gleitschalendurchmessers eingestellt wird.

15. Verfahren nach einem der Ansprüche 10 bis 14, **dadurch gekennzeichnet, daß** die Beschichtungsrate im Scheitelbereich auf mindestens 20 nm/s eingestellt wird.

## Claims

1. Sliding bearing shell having a support body and having at least one metallic sliding layer which is applied by means of electron beam vapour deposition and which has, in a matrix material, at least one finely dispersed component whose atomic weight is greater than that of the matrix material, **characterized in**
**that** the concentration of the finely dispersed component (7) decreases continuously from the summit region (8) of the sliding bearing shell (1) to the surface region (9).

2. Sliding bearing shell according to Claim 1, **characterized in that** the concentration of the finely dispersed component (7) is a factor of 1.2 to 1.8 greater in the summit region (8) than in the surface region (9).

3. Sliding bearing shell according to Claim 1 or 2, **characterized in that** the concentration of the finely dispersed component (7) is constant over the thickness of the sliding layer (6).

4. Sliding bearing shell according to either of Claims 1 and 2, **characterized in that** the concentration of the finely dispersed component (7) increases continuously from the lower to the upper region of the sliding layer (6).

5. Sliding bearing shell according to any of Claims 1 to 4, **characterized in that** the concentration of the finely dispersed component (7) in the summit region (8) is between 10 and 70% by mass.

6. Sliding bearing shell according to either of Claims 4 and 5, **characterized in that** the concentration of finely dispersed component (7) is up to twice as great in the upper region of the sliding layer (6) than in the lower region.

7. Sliding bearing shell according to any of Claims 1 to 6, **characterized in that** the matrix material consists of aluminium and that the finely dispersed component (7) consists of tin, lead, bismuth and/or antimony.

8. Sliding bearing shell according to any of Claims 1 to 7, **characterized in that** the sliding layer (6) has, as a further alloy component, copper, zinc, silicon, manganese and/or nickel, individually or in combination in an amount of up to 5% by mass.

9. Sliding bearing shell according to any of Claims 1 to 8, **characterized in that** the thickness of the sliding layer (6) is uniform over the total circumference.

10. Method for the production of a sliding bearing shell having at least one sliding layer of a metallic alloy which is applied to a support body in a coating chamber by means of electron beam vapour deposition and which has, in a matrix material, a finely dispersed component whose atomic weight is greater than that of the matrix material, **characterized in**
**that** a gas is adjusted to a pressure of 0.1 to 5 Pa during the coating process in the summit region of the bearing shell.

11. Method according to Claim 10, **characterized in that** the gas pressure is changed continuously during the vapour deposition process.

12. Method according to Claim 11, **characterized in that** the gas pressure is increased continuously from 0.1 Pa at the beginning to 1 Pa at the end of the vapour deposition process.

13. Method according to any of Claims 10 to 12, **characterized in that** a noble gas argon, helium or neon is used as the gas.

14. Method according to any of Claims 10 to 13, **characterized in that** the perpendicular distance from the sliding bearing shell to the vaporization crucible is adjusted to 2 to 7 times the sliding shell diameter.

15. Method according to any of Claims 10 to 14, **characterized in that** the coating rate in the summit region is adjusted to at least 20 nm/s.

## Revendications

1. Coquille de coussinet lisse avec un élément de support et au moins une couche antifriction métallique, qui est déposée par métallisation sous vide par bombardement d'électrons et qui comprend dans un matériau matriciel au moins un composant finement dispersé dont le poids atomique est supérieur à celui du matériau matriciel, **caractérisée en ce que** la concentration du composant finement dispersé (7) décroît de façon continue depuis la zone de creux ou de sommet (8) de la coquille de coussinet lisse (1 ) jusqu'à la zone des surfaces latérales ou surfaces de séparation (9).

2. Coquille de coussinet lisse selon la revendication 1, **caractérisée en ce que** la concentration du composant finement dispersé (7) dans la zone de creux (8) est supérieure d'un facteur de 1,2 à 1,8 par rapport à celle de la zone des surfaces latérales (9).

3. Coquille de coussinet lisse selon la revendication 1 ou 2, **caractérisée en ce que** la concentration du composant finement dispersé (7) est constante sur toute l'épaisseur de la couche antifriction (6).

4. Coquille de coussinet lisse selon la revendication 1 ou 2, **caractérisée en ce que** la concentration du composant fmement dispersé (7) augmente de façon continue de la zone inférieure à la zone supérieure de la couche antifriction (6).

5. Coquille de coussinet lisse selon l'une des revendications 1 à 4, **caractérisée en ce que** la concentration du composant finement dispersé (7) est comprise entre 10 et 70 % en masse dans la zone de creux (8).

6. Coquille de coussinet lisse selon l'une des revendications 4 ou 5, **caractérisée en ce que** la concentration du composant finement dispersé (7) de la zone supérieure de la couche antifriction (6) est jusqu'à deux fois supérieure à celle de la zone inférieure.

7. Coquille de coussinet lisse selon l'une des revendications 1 à 6, **caractérisée en ce que** le matériau matriciel se compose d'aluminium et que le composant finement dispersé (7) est constitué d'étain, de plomb, de bismuth et/ou d'antimoine.

8. Coquille de coussinet lisse selon l'une des revendications 1 à 7, **caractérisée en ce que** la couche antifriction (6) comprend jusqu'à 5 % en masse d'autres composants d'alliage, tels que le cuivre, le zinc, le silicium, le manganèse et/ou le nickel, seuls ou en combinaison.

9. Coquille de coussinet lisse selon l'une des revendications 1 à 8, **caractérisée en ce que** l'épaisseur de la couche antifriction (6) est uniforme sur toute l'étendue de la coquille.

10. Procédé de fabrication d'une coquille de coussinet lisse comprenant au moins une couche antifriction constituée d'un alliage métallique, qui est déposée sur un élément de support dans une chambre de dépôt par métallisation sous vide par bombardement d'électrons et qui comprend dans un maténau matriciel un composant finement dispersé, dont le poids atomique est supérieur à celui du matériau matriciel, **caractérisé en ce que**, pendant le processus de dépôt dans la zone de creux ou de sommet de la coquille de coussinet, un gaz est ajusté à une pression comprise entre 0,1 et 5 Pa.

11. Procédé selon la revendication 10, **caractérisé en ce que** la pression gazeuse est continuellement modifiée pendant le processus de métallisation sous vide

12. Procédé selon la revendication 11, **caractérisé en ce que** la pression gazeuse est augmentée de façon continue, de 0,1 Pa au début à 1 Pa à la fin du processus de métallisation sous vide.

13. Procédé selon l'une des revendications 10 à 12, **caractérisé en ce que** le gaz utilisé est un gaz noble, argon, hélium ou néon.

14. Procédé selon l'une des revendications 10 à 13, **caractérisé en ce que** l'écart vertical entre la coquille de coussmet lisse et le creuset de vaponsation est ajusté pour être 2 à 7 fois l'équivalent du diamètre de la coquille de coussinet lisse

15. Procédé selon t'une des revendications 10 à 14, **caractérisé en ce que** la vitesse de dépôt dans la zone de creux ou de sommet est ajustée à au moins 20 nm par seconde.
